# EUROPÄISCHE PATENTANMELDUNG

(11) **EP 4 742 878 A1**
(43) Veröffentlichungstag der Anmeldung: **13.05.2026**
(21) Anmeldenummer: 25202741.2
(22) Anmeldetag: 17.09.2025
(51) Int. Cl.: H10N 60/01, H10N 60/12

(54) **BAUELEMENT MIT JOSEPHSON-KONTAKT, MAGNETFELDSENSOR SOWIE VERFAHREN ZUR HERSTELLUNG**

(30) Priorität: 12.11.2024 DE 102024133048
(71) Anmelder: Forschungszentrum Jülich GmbH, 52428 Jülich (DE)
(72) Erfinder: Faley, Mikhail, 52428 Jülich (DE)
(74) Vertreter: Gille Hrabal Partnerschaftsgesellschaft mbB Patentanwälte

(57) **Zusammenfassung**

Die Erfindung betrifft ein Bauelement mit einer Oberfläche mit einer Stufe, die eine obere Ebene (3) der Oberfläche von eine unteren Ebene (4) der Oberfläche trennt, mit Supraleitern (8, 9, 10) auf der Oberfläche, wobei bei den Kanten der Stufe jeweils ein Josephson-Kontakt vorliegt, wobei ein jeder Josephson-Kontakt durch zwei Supraleiter und einer Barriere (11, 12) zwischen den Supraleitern (8, 9, 10) gebildet ist, dadurch gekennzeichnet, dass der kritische Strom des einen Josephson-Kontakts größer ist als der kritische Strom des anderen Josephson-Kontakts.

Die Erfindung betrifft einen Magnetfeldsensor mit dem Bauelement sowie ein Verfahren zur Herstellung.

## Beschreibung

Die Erfindung betrifft ein elektronisches Bauelement mit Josephson-Kontakt, einen Magnetfeldsensor mit dem Bauelement sowie ein Verfahren zur Herstellung.

Ein Josephson-Kontakt ist eine supraleitende Struktur, die auf dem sogenannten Josephson-Effekt basiert. Der Josephson-Effekt beschreibt das Verhalten von Supraleitern, die durch eine Barriere getrennt sein können. Die Barriere kann elektrisch leitend, schwach supraleitend oder ein elektrischer Isolator sein. Ist die Barriere ein Isolator, dann können Cooper-Paare (gepaarte Elektronen oder Löcher) durch diese Barriere "tunneln" ("Tunneleffekt").

Die Barriere kann eine Korngrenze zwischen zwei einkristallinen Supraleitern sein. Es kann dann ein Strom fließen, ohne dafür eine externe Spannungsquelle zu benötigen. Eine Voraussetzung dafür ist, dass der kritische Strom nicht überschritten wird. Der kritische Strom ist die maximale Stromstärke, die durch einen Josephson-Kontakt ohne Spannungsabfall fließen kann ("Gleichstrom-Josephson-Effekt"). Übersteigt der durch den Josephson-Kontakt fließende Strom der kritische Strom, dann zeigt der Josephson-Kontakt einen elektrischen Widerstand ("Wechselstrom-Josephson-Effekt"). Es ist dann also eine elektrische Spannung erforderlich, damit ein elektrischer Strom durch die Barriere hindurchfließen kann. Ein Supraleiter ist ein Material, in dem ein elektrischer Strom unterhalb einer bestimmten Temperatur (der sogenannten Sprungtemperatur T_{C}) ohne Spannungsabfall fließen kann.

Ein elektronisches Bauelement mit Josephson-Kontakt wird in der Quantentechnologie und in der Präzisionsmesstechnik verwendet. Ein elektronisches Bauelement mit Josephson-Kontakt ermöglicht den Bau von supraleitenden Quantenbits (Qubits) in Quantencomputern sowie extrem empfindliche Magnetfeldsensoren, sogenannte SQUIDs (Superconducting Quantum Interference Devices).

Die -Barriere des Josephson-Kontakts kann mithilfe einer Stufe eines Substrats hergestellt werden. Ein supraleitendes Material kann so auf einer Oberfläche mit einer Stufe abgeschieden werden, dass zumindest zwei einkristalline Bereiche entstehen, die durch eine Korngrenze getrennt sind. Die durch eine Korngrenze getrennten einkristallinen Bereiche können dann zwei Supraleiter bilden. Die Korngrenze bei einer Kante einer Stufe kann eine Barriere eines Josephson-Kontakts zwischen den beiden Supraleitern sein.

Da eine Stufe zwei Kanten hat, kann ein solches Bauteil zwei Josephson-Kontakte umfassen. Ein Bauteil mit einer Stufe und zwei Josephson-Kontakten bei den beiden Kanten einer Stufe kann ungünstig für eine weitere Verwendung sein, also beispielsweise für eine Verwendung in einem Magnetfeldsensor oder für eine Verwendung als Qubit.

Aus der Druckschrift WO 2013/149607 A1 ist ein elektronisches Bauelement mit Josephson-Kontakt sowie ein Verfahren zu seiner Herstellung bekannt.

Es ist Aufgabe der Erfindung, ein Bauteil mit Josephson-Kontakt an einer Kante einer Stufe weiterzuentwickeln. Insbesondere soll das Bauteil für einen Einsatz in einem Magnetfeldsensor oder für den Bau eines Qubits gut geeignet sein.

Die Aufgabe wird durch ein Bauteil mit den Merkmalen des ersten Anspruchs gelöst. Ein nebengeordneter Anspruch betrifft einen Magnetfeldsensor mit dem Bauteil. Ein anderer nebengeordneter Anspruch betrifft ein Verfahren zur Herstellung. Die abhängigen Ansprüche betreffen verbesserte Ausgestaltungen.

Zur Lösung der Aufgabe kann ein Bauelement eine Oberfläche mit einer Stufe umfassen. Die Stufe kann eine obere Ebene der Oberfläche von einer unteren Ebene der Oberfläche trennen. Es können sich Supraleiter auf der Oberfläche befinden. Bei den Kanten der Stufe kann jeweils ein Josephson-Kontakt vorhanden sein, also eine Barriere, die zwei Supraleiter trennt. Der kritische Strom des einen Josephson-Kontakts kann größer sein als der kritische Strom des anderen Josephson-Kontakts. Die Querschnitte der Supraleiter, die an die eine Barriere angrenzen, können größer als die Querschnitte der Supraleiter sein, die an die andere Barriere angrenzen.

Auf einer Ebene kann eine supraleitende Schicht reproduzierbar einkristallin abgeschieden werden oder abgeschieden worden sein. Auf einer Ebene sind dann keine Barrieren vorhanden. Mit Kante ist ein Übergang von einer Ebene zu einer nächsten Ebene gemeint, bei dem durch Abscheidung eines supraleitenden Materials eine Korngrenze und damit eine Barriere zwischen zwei einkristallinen Supraleitern reproduzierbar entstehen kann oder entstanden ist.

Ein solches Bauelement mit Stufe und Josephson-Kontakten mit hinreichend unterschiedlichen kritischen Strömen bei den Kanten der Stufe ist für viele Anwendungen besser geeignet als ein Bauelement mit zwei nahezu gleichen Josephson-Kontakten bei Kanten einer Stufe. Es kann ausgenutzt werden, dass der kritische Strom des einen Josephson-Kontakts größer als der kritische Strom des anderen Josephson-Kontakts ist. Die kritischen Ströme können sich um einen Faktor 2 oder mehr unterscheiden. Der Betriebsbereich des Vorstroms eines Geräts mit einer solchen Komponente kann ein Bereich in der Nähe des kleinsten kritischen Stroms sein.

Ein kritischer Strom, der kleiner ist als der andere kritische Strom, sollte für eine Anwendung insbesondere im Fall eines SQUIDs vorteilhaft wenigstens 10 µA oder wenigstens 20 µA betragen, um negative Einflüsse aufgrund von Rauschen klein zu halten. Ein kritischer Strom, der kleiner ist als der andere kritische Strom, sollte für eine Anwendung insbesondere im Fall eines SQUIDs vorteilhaft aus Gründen der Empfindlichkeit nicht mehr als 200 µA oder nicht mehr als 100 µA oder am besten nicht mehr als 50 µA betragen. Entsprechend sollte die Größe von Querschnitten von Barrieren ausgewählt werden.

Die Supraleiter bestehen grundsätzlich aus einkristallinem Material, um die Bildung von Korngrenzen an Kanten einer Stufe ausnutzen zu können.

Die Supraleiter können aus YBa₂Cu₃O_{7**-**x} (YBCO) gebildet sein.

Der kritische Strom des einen Josephson-Kontakts kann um einen Faktor 3 oder um einen Faktor 5 oder um einen 10 größer sein als der kritische Strom des anderen Josephson-Kontakts. Die Querschnitte der Supraleiter des einen Josephson-Kontakts können entsprechend größer sein als die Querschnitte der Supraleiter des anderen Josephson-Kontakts, um dies zu erreichen. Dadurch ist es möglich, mit nur einem Josephson-Kontakt zuverlässig und sicher einen Arbeitsbereich einzustellen, der den kleinsten kritischen Strom aufweist.

Der kritische Strom des einen Josephson-Kontakts bei der oberen Kante 6 der Stufe kann größer sein als der kritische Strom des Josephson-Kontakts bei der unteren Kante 7. Die Querschnitte der Supraleiter des Josephson-Kontakts bei der oberen Kante 6 können daher größer sein als die Querschnitte der Supraleiter des Josephson-Kontakts bei der unteren Kante 7. Beispielsweise ist durch eine dickere Schutzschicht aus Fotolack an der Unterkante 7 diese Ausgestaltung zu bevorzugen.

Die obere Ebene der Oberfläche kann von der unteren Ebene der Oberfläche durch eine Ebene getrennt sein, die mit der oberen Ebene sowie mit der unteren Ebene einen Winkel einschließt, der zwischen 130° und 140° oder zwischen 133° und 137° liegt oder der 135° beträgt. Es lassen sich dann besonders geeignete kristallographische Richtungen sowie Korngrenzen erzielen, so zum Beispiel eine [001] - Richtung auf den Ebenen und eine [011] - Richtung auf der schrägen Ebene. Dies gilt beispielsweise für das Wachstum von YBCO auf einem einkristallinen Substrat aus MgO.

Eine Kristallorientierung beschreibt die räumliche Ausrichtung der Kristallgitterebenen innerhalb eines Kristalls. Da Kristalle ein regelmäßiges, dreidimensionales Gitter aus Atomen oder Molekülen besitzen, können verschiedene Kristallbereiche unterschiedliche Ausrichtungen haben, je nachdem, wie die Gitterebenen relativ zu den äußeren Raumachsen (z. B. der Probenoberfläche) orientiert sind. Ein Kristallgitter hat definierte Achsen, die durch die Anordnung der Atome im Gitter bestimmt werden. Diese Achsen (oft als *a*, *b,* und *c*-Achsen bezeichnet) legen die Orientierung des Gitters fest. Kristallographische Richtungen können mit Miller-Indizes (z. B. [100], [110], [111]) beschrieben werden, die die Orientierung von Richtungen oder Ebenen im Gitter relativ zu den kristallographischen Achsen darstellen.

Das Bauelement kann ein einkristallines Substrat mit Stufe umfassen, um besonders geeignete Kristallorientierungen erzielen zu können.

Das Substrat kann aus MgO bestehen, um besonders geeignete Kristallorientierungen erzielen zu können.

Auf dem Substrat kann eine erste Schicht aus YBCO aufgebracht sein. Auf der ersten Schicht kann eine zweite Schicht aus SrTiO₃ aufgebracht sein. Auf der zweiten Schicht kann eine dritte Schicht aus YBCO aufgebracht sein. Die dritte Schicht kann dann besonders leistungsfähige Supraleiter umfassen. In der untersten Schicht können Wachstumsfehler aufgrund einer nicht perfekten Oberfläche des Substrats, so zum Beispiel aufgrund von Verunreinigungen, auftreten. Wachstumsfehler in der untersten Schicht werden durch einen solchen Schichtaufbau nicht auf die oberste, aus YBCO gebildet Schicht übertragen. Dies wird aufgrund der die kubischen Elementarzellen bzw. des kubischen Kristallsystems von SrTiO₃ vermieden. Gewünschte Kristallrichtungen bleiben durch die Auswahl von SrTiO₃ dennoch in der obersten aus YBCO gebildeten Schicht erhalten. Dies gilt insbesondere für c-Achsenwachstum. Eine Übertragung eines unerwünschten Achsenwachstums von einer unteren YBCO -Schicht auf eine obere YBCO-Schicht kann vermieden werden. Eine unerwünschtes Achsenwachstum kann eine a-Achsenwachstum sein. Anstelle von SrTiO₃ kann auch ein anderes kristallines Material mit kubischen Elementarzellen ausgewählt werden, welches kristallographische Richtungen und damit Korngrenzen von einer angrenzenden YBCO Schicht auf eine andere angrenzende YBCO Schicht übertragen kann.

Die zweite Schicht kann dünner als die dritte Schicht sein. Die dritte Schicht kann dann weiter verbessert besonders leistungsfähige Supraleiter umfassen.

Die erste Schicht kann dünner als die zweite Schicht sein. Der Materialeinsatz kann so minimiert werden.

Die Höhe der Stufe des Substrats kann 300 nm oder wenigstens 400 nm oder wenigstens 600 nm betragen, beispielsweise aus Herstellungsgründen. Die Höhe der Stufe des Substrats kann aus Gründen der Minimierung des Prozess- und Material-Aufwands weniger als 1500 nm oder weniger als 1200 nm oder weniger 800 nm betragen.

Die Höhe (bzw. Dicke) der ersten Schicht kann wenigstens 1 nm oder wenigstens 2 nm oder wenigstens 3 nm betragen. Die Höhe (bzw. Dicke) der ersten Schicht kann nicht mehr als 50 nm oder nicht mehr als 20 nm oder nicht mehr als 5 nm betragen.

Die Höhe (bzw. Dicke) der zweiten Schicht kann wenigstens 10 nm oder wenigstens 20 nm oder wenigstens 30 nm betragen. Die Höhe (bzw. Dicke) der zweiten Schicht kann nicht mehr als 100 nm oder nicht mehr als 40 nm oder nicht mehr als 30 nm betragen.

Die Höhe (bzw. Dicke) der dritten Schicht kann wenigstens 100 nm oder wenigstens 150 nm oder wenigstens 200 nm betragen. Eine Dicke von wenigstens 200 nm oder wenigstens 150 nm ist besonders zu bevorzugen, um Rauscheffekte zuverlässig vermeiden zu können. Eine Dicke von 100 nm kann aber auch genügen. Die Höhe (bzw. Dicke) der dritten Schicht kann nicht mehr als 500 nm oder nicht mehr als 400 nm oder nicht mehr als 300 nm betragen. Es kann so erreicht werden, dass günstige Querschnitte erzielt werden können, ohne dass die Breite der Schicht dafür übermäßig klein sein muss.

Die Breite der Supraleiter, die an die eine Barriere angrenzen, also die Breite bei der einen Barriere, können in Aufsicht gesehen wenigstens 1 µm oder wenigstens 1,5 µm oder wenigstens 2 µm betragen oder wenigstens 3 µm betragen. Die Breite der Supraleiter, die an die eine Barriere angrenzen, können in Aufsicht gesehen nicht mehr als 10 µm oder nicht mehr als 8 µm oder nicht mehr als 5 µm betragen. Diese Auswahl kann zu günstigen Querschnitten beitragen, um beispielsweise zuverlässig Magnetfelder ohne Probleme aufgrund von Rauschen messen zu können und ohne dafür einen übermäßig großen Herstellungsaufwand in Kauf nehmen zu müssen. Schichten können bei kleinen Breiten von wenigen µm wie Streifen geformt sein.

Die Breite der Supraleiter, die an die andere Barriere angrenzen, können in Aufsicht gesehen wenigstens 200 nm oder wenigstens 350 nm betragen oder wenigstens 500 nm betragen. Die Breite der Supraleiter, die an die andere Barriere angrenzen, können in Aufsicht gesehen nicht mehr als 1000 nm oder nicht mehr als 800 nm oder nicht mehr als 700 nm betragen.

Es ist möglich, dass die Breite der Supraleiter bei der einen Barriere wenigstens 1 µm oder wenigstens 2 µm beträgt und die Breite der Supraleiter bei der anderen nicht supraleitenden Barriere nicht mehr als 800 nm oder nicht mehr als 500 nm beträgt.

Die Breite des Supraleiters, der sich zwischen zwei Barrieren befindet, kann sich also verändern. Es ist aus Gründen der Leistungsfähigkeit zu bevorzugen, dass sich auch die Breite des Supraleiters wieder vergrößert, der bei der anderen supraleitenden Barriere eine nur geringe Breite aufweist. Die Breite von zwei Supraleitern können sich als in Richtung der anderen supraleitenden Barriere verjüngen, so zum Beispiel in Aufsicht gesehen stufenförmig verjüngen.

Die Dicke der Supraleiter können gleich sein oder zumindest im Wesentlichen gleich.

Das Bauelement ist insbesondere Teil eines Magnetfeldsensors. Der Magnetfeldsensor ist dann ein SQUID. Der Name SQUID steht für Supraleitendes Quanten-Interferenz-Bauelement. SQUIDs werden unter anderem in der Medizin, Geophysik und in der Grundlagenforschung eingesetzt. Ein SQUID besteht aus einem supraleitenden Ring mit einem oder zwei Josephson-Kontakten.

Um das Bauteil herzustellen, kann auf einem Substrat mit einer Stufe eine Schicht aus supraleitendem Material aufgetragen werden. Die Schicht aus supraleitendem Material kann mittelbar auf dem Substrat aufgetragen werden. Es können also ein oder mehrere weitere Schichten auf dem Substrat aufgetragen worden sein, die sich dann zwischen dem Substrat und dem erstgenannten supraleitenden Material befinden können. Im Anschluss daran kann die Breite der Schicht bei einer Kante der Stufe verkleinert werden.

Nach dem Auftragen von ein oder mehreren Schichten können die Schichten strukturiert werden. Das Strukturieren kann mit Hilfe von Ionenstrahlätzen oder mit Hilfe von Plasmaätzen erfolgen. Es kann so strukturiert worden sein, dass die ein oder mehreren Schichten einen Streifen bilden, der sich von der oberen Ebene der Stufe bis zur unteren Ebene der Stufe erstreckt. Die Breite des Streifens kann vorzugsweise wenigstens 1 µm oder wenigstens 2 µm oder wenigstens 3 µm betragen. Die Breite des Streifens kann vorzugsweise nicht mehr als 10 µm oder nicht mehr als 5 µm oder nicht mehr als 3 µm betragen. An einer Kante der Stufe, vorzugsweise an der tiefergelegenen Kante der Stufe, kann der Streifen verengt werden. Die Breite, die durch das Verengen entsteht, kann nicht mehr als 1000 nm oder nicht mehr als 800 nm oder nicht mehr als 600 nm betragen. Die Breite, die durch das Verengen entsteht, kann wenigstens 200 nm oder wenigstens 400 nm oder wenigstens 600 nm betragen. Das Verengen kann beispielsweise mit Hilfe eines fokussierten Ionenstrahls erfolgen.

Ionenstrahlätzen ist ein Verfahren, bei dem hochenergetische Ionen gezielt auf eine Materialoberfläche geschossen werden, um spezifische Bereiche abzutragen und damit gewünschte Strukturen in der Schicht zu erzeugen. Durch das gezielte Abtragen entstehen vertiefte und erhabene Bereiche.

Die oberste Schicht kann vorab durch eine Fotomaske abgedeckt worden sein, die gewünschte Bereiche für die Bearbeitung freilässt. Die Fotomaske kann nach der Bearbeitung entfernt werden. Dies ist aber für das Funktionieren des Bauteils nicht erforderlich.

Während des Ionenstrahlätzens wird ein Ionenstrahl aus geladenen Teilchen erzeugt und auf die abzutragenden ein oder mehreren Schichten gelenkt. Die Ionen prallen mit hoher Energie auf das Material der ein oder mehreren Schichten und schlagen dabei gezielt Atome heraus, wodurch sich das Material an den ungeschützten Stellen abträgt. An den durch die Maske geschützten Stellen bleiben die ein oder mehreren Schichten hingegen unberührt.

Ionenstrahlätzen ist im Vergleich zu anderen Strukturierungstechniken (z. B. chemisches Ätzen) äußerst präzise und ermöglicht die Bearbeitung extrem harter Materialien. Zudem kann es Strukturen mit nahezu atomarer Präzision herstellen.

Beim Plasmaätzen wird ein Plasma aus reaktiven Gasen genutzt, um das Material von ein oder mehreren Schichten abzutragen und präzise Strukturen zu erzeugen. Beim Plasmaätzen werden Gase (wie Fluor-, Chlor- oder Sauerstoffverbindungen) in einer Vakuumkammer durch ein elektrisches Feld in einen Plasmazustand versetzt. Im Plasma entstehen dabei reaktive Ionen und Radikale, die auf die Oberfläche des zu bearbeitenden Materials einwirken. Das Plasmaätzen kann je nach gewünschter Strukturierung auf unterschiedliche Weise durchgeführt werden, so zum Beispiel wie folgt beschrieben:
Reaktives Ionenätzen (RIE): Hierbei wird das Material durch eine Kombination aus chemischen und physikalischen Prozessen abgetragen. Die reaktiven Ionen des Plasmas reagieren chemisch mit der Oberfläche und bilden dabei flüchtige Verbindungen, die entfernt werden. Gleichzeitig sorgt die physikalische Bombardierung durch die Ionen für eine zusätzliche Abtragung. Dieser Ansatz ermöglicht eine sehr präzise und anisotrope Ätzung, bei der die Seitenwände der Strukturen sehr steil und kontrolliert geformt werden.

Isotropes Plasmaätzen: Hier erfolgt das Ätzen rein chemisch, wobei das Plasma chemisch auf die gesamte Oberfläche des Materials einwirkt. Dieser Prozess ist gleichmäßig in alle Richtungen (isotrop) und wird vor allem dann verwendet, wenn eine gleichmäßige Abtragung über die gesamte Oberfläche gewünscht ist.

Zunächst wird für eine Strukturierung durch Plasmaätzen eine Fotomaske oder ein anderes Schutzmaterial auf die zu strukturierenden ein oder mehreren Schichten aufgebracht, das nur die zu ätzenden Bereiche unbedeckt lässt. In einer Plasmaanlage wird ein Gasgemisch durch elektromagnetische Felder ionisiert und ein reaktives Plasma erzeugt. Die Ionen und Radikale des Plasmas reagieren mit dem freiliegenden Material und lösen gezielt chemische Bindungen auf, sodass das Material in den ungeschützten Bereichen abgetragen wird. Die Abtragung erfolgt dabei je nach Technik (RIE, isotrop oder DRIE) anisotrop oder isotrop.

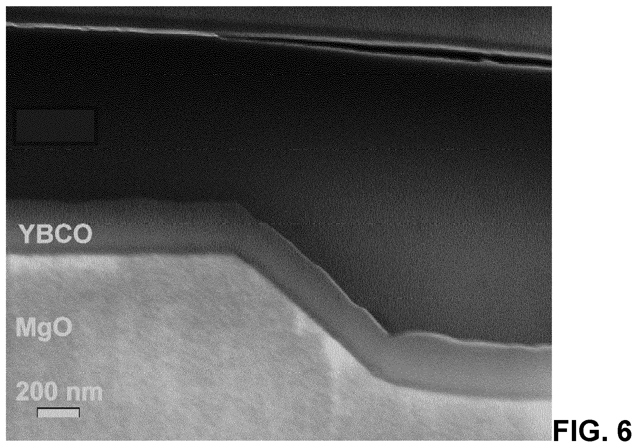

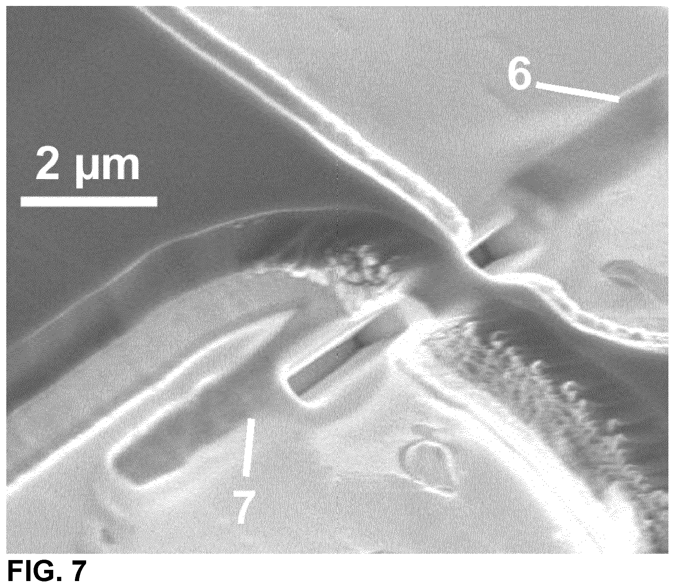

Nach Abschluss des Plasma- oder lonenstrahlätzprozesses kann der supraleitende Streifen an der Stelle einer der beiden Stufenkanten mit Barrieren verschmälert werden, beispielsweise mittels eines fokussierten Ionenstrahls: siehe Fig.7. Die verbleibende Maske kann an bestimmten Stellen weggeätzt werden und kann an anderen Stellen supraleitende Schichten vor Verunreinigungen und Beschädigung schützen. Besonders wirksam kann dieser Schutz bei Barrieren an unteren Stufenkanten sein, da die Photomaske dort besonders dick sein kann: siehe Fig. 6.

Nach Abschluss der Ätzung zum Beispiel durch fokussierten Ionenstrahl kann die Maske entfernt werden, was aber nicht erforderlich ist. Es kann vorteilhaft sein, eine Maske aus Schutzgründen nicht zu entfernen.

Plasmaätzen bietet eine hohe Präzision und Flexibilität, da sowohl die chemischen als auch physikalischen Parameter des Prozesses präzise gesteuert werden können. Es ermöglicht die Herstellung feinster Strukturen im Nanometerbereich und bietet gleichzeitig die Kontrolle über das Ätzprofil und die Strukturgeometrie.

Das Material der Maske kann ein Lack, beispielsweise ein Fotolack oder Elektronenstrahllack, sein.

YBCO ist ein mögliches supraleitendes Material, welches besonders zu bevorzugen ist. Mit YBCO ist YBa₂Cu₃O₇-x gemeint. X kann größer als 0 sein, so zum Beispiel größer als 0,01 oder größer als 0,03. X kann kleiner als 1 oder kleiner als 0,5 oder kleiner als 0,1 oder kleiner als 0,06 sein. X ist besonders bevorzugt 0,04 bis 0,07. YBCO ist ein Hochtemperatursupraleiter mit einer Sprungtemperatur von etwa 92 K, was über der Siedetemperatur von flüssigem Stickstoff (77 K) liegt. Durch die einkristalline Struktur erreicht YBCO eine besonders hohe Stromdichte und geringe Störstellen, was die Supraleitfähigkeit stabilisiert. Yttrium in YBCO kann durch Seltenerdelemente La, Nd, Sm, Eu, Dy, Ho, Yb oder Lu ersetzt werden.

Es sind aber auch andere supraleitende Materialien möglich wie zum Beispiel einkristallines Bismut-Strontium-Calcium-Kupfer-Oxid (BSCCO, Bi₂Sr₂Ca₂Cu₃O₁₀). BSCCO ist ebenfalls ein Hochtemperatursupraleiter mit einer Sprungtemperatur von etwa 108 K. Einkristalline supraleitende Schichten auf Basis von Lanthan-Barium-Kupfer-Oxid, Thallium-Barium-Calcium-Kupfer-Oxid oder Quecksilber-Barium-Calcium-Kupfer-Oxid sind ebenfalls möglich. Allerdings sind sie im Vergleich zu YBCO technologisch deutlich schwieriger herzustellen.

Eine Barriere bei einer Kante einer wird grundsätzlich durch Korngrenzen erzielt, die zwei einkristalline Bereiche trennen.

Es zeigen:
Figur 1: Bauelement mit Josephson-Kontakten;
Figur 2: Schnitt durch das Bauelement mit Josephson-Kontakten;
Figur 3: Aufsicht auf das Bauelement mit Josephson-Kontakten;
Figur 4: Elektronenmikroskopaufnahme einer unteren Kante einer Stufe;
Figur 5: weiter vergrößerte Elektronenmikroskopaufnahme;
Figur 6: Elektronenmikroskopaufnahme eines Bauteils mit Stufe;
Figur 7: Elektronenmikroskopische Aufnahme einer Verengung eines supraleitenden Streifens mittels fokussiertem Ionenstrahl an der Unterkante 7 einer 45° Stufe auf einem einkristallinen MgO Substrat.

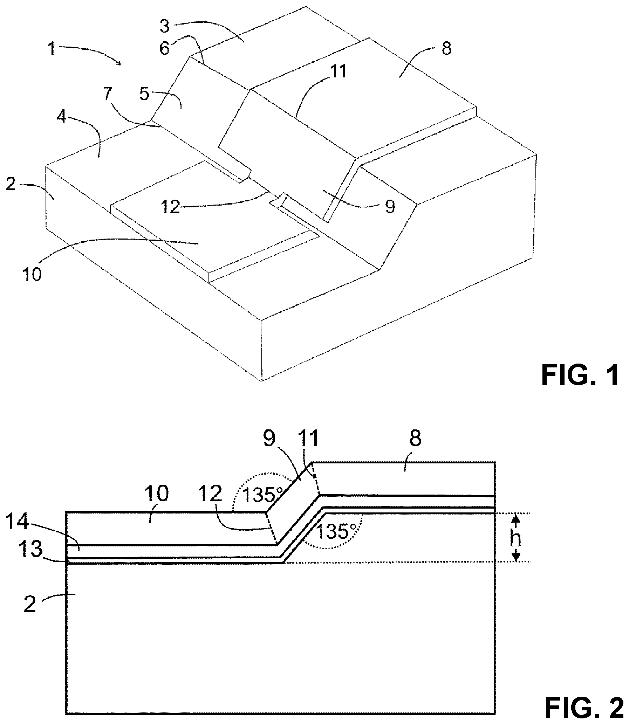

Die Figur 1 zeigt ein Bauelement 1 mit einem Substrat 2, das eine Stufe umfassen kann. Die Stufe kann eine obere Ebene 3 von einer unteren Ebene 4 trennen. Die obere Ebene 3 und die untere Ebene 4 können jeweils in eine Ebene 5 der Stufe einmünden. Eine obere Kante 6 kann die obere Ebene 3 von der Ebene 5 der Stufe trennen. Eine untere Kante 7 kann die untere Ebene 4 von der Ebene 5 der Stufe trennen. Die Ebene 5 der Stufe kann schräg unter einem 45° Winkel ansteigen. Die obere Ebene 3 und die untere Ebene 4 schließen dann mit der Ebene 5 der Stufe einen Winkel ein, der jeweils 135° beträgt.

Auf den Ebenen 3, 4, 5 des Substrats 1 können ein oder mehrere Schichten zur Bildung von Supraleitern 8, 9, 10 abgeschieden worden sein. Die Supraleiter können streifenförmig strukturiert worden sein. Ein Supraleiter 8 auf der oberen Ebene 3 kann von einem Supraleiter 9 auf der Ebene 5 der Stufe durch eine Barriere 11 getrennt sein. Ein Supraleiter 10 auf der unteren Ebene 4 kann von dem Supraleiter 9 auf der Ebene 5 der Stufe durch eine Barriere 12 getrennt sein.

Die Breite der Supraleiter 9 und 10 können bei der Barriere 12 verkleinert worden sein, wie dies in der Figur 1 zu erkennen ist. Dadurch kann erreicht worden sein, dass der kritische Strom des Josephson-Kontakts, der die eine Barriere 11 umfasst, wesentlich größer ist als der kritische Strom des Josephson-Kontakts, der die andere Barriere 11 umfasst.

Die Figur 2 zeigt einen Schnitt durch das Bauelement aus Figur 1. Das beispielsweise aus MgO bestehenden einkristallinem Substrat 2 kann eine Schicht 13 abgeschieden worden sein. Die Schicht 13 kann aus einkristallinen YBCO Schichten bestehen, die durch Korngrenzen voneinander getrennt sein können. Die Schicht 13 kann ca. 4 nm hoch bzw. dick sein. Auf der Schicht 13 kann eine Schicht 14 abgeschieden worden sein. Die Schicht 14 kann aus einkristallinen SrTiO₃ Schichten bestehen, die durch Korngrenzen voneinander getrennt sein können. Die Schicht 14 kann ca. 30 nm hoch bzw. dick sein. Auf die Schicht 14 kann YBCO abgeschieden worden sein, die aus durch Korngrenzen getrennte supraleitenden Schichten 8, 9, 10 gebildet ist. Diese Schicht kann ca. 200 nm sein.

Die Höhe h der Stufe kann 600 nm betragen.

Die supraleitenden Schichten 8 und 9 können einen Winkel einschließen, der ca. 135° groß sein kann. Die supraleitenden Schichten 9 und 10 können einen Winkel einschließen, der ca. 135° groß sein kann.

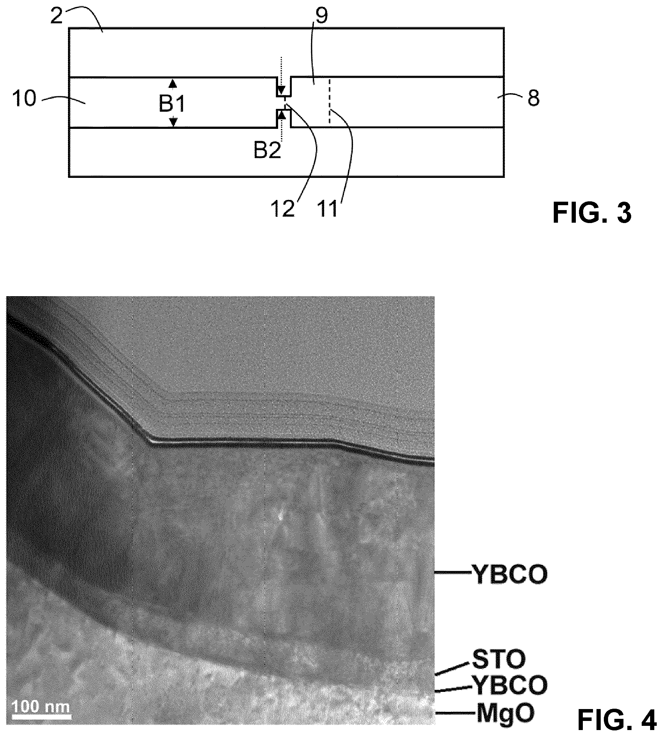

Die Figur 3 zeigt Aufsicht auf das Bauelement aus Figur 1. Die Supraleiter bzw. supraleitenden Schichten 8, 9 und 10 können eine Breite B1 aufweisen, die ca. 3 µm betragen kann. Die Supraleiter 9 und 10 können sich zur Korngrenze 12 hin stufenförmig verjüngen. Die Breite B2 kann dann nur noch ca. 600 nm betragen. Die Länge des Abschnitts, der die Breite B2 aufweist, kann kleiner sein als die Breite B2, um zu guten Ergebnissen zu gelangen: zum Beispiel damit die parasitäre Induktivität der schmalen Brücke möglichst gering ist. Dies ist in der Figur 1 zu sehen.

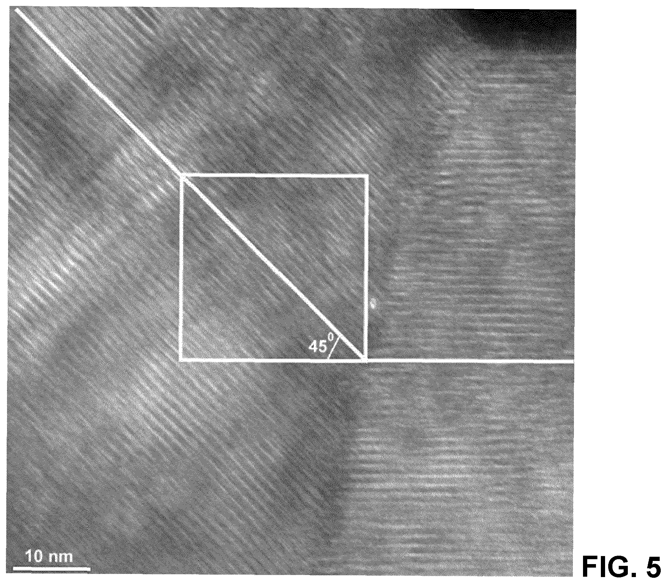

Die Figuren 4 und 5 zeigen hochaufgelöste TEM-Bilder eines Schnitts durch eine untere Kante einer Stufe eines hergestellten Bauteils mit einer Korngrenze. 45° ist der Neigungswinkel zwischen den ab-Ebenen von YBCO, das zunächst auf der (001)-orientierten MgO-Substratoberfläche und auf der (011)-Ebene von MgO gewachsen ist, was ungefähr parallel zum Neigungswinkel der Stufe ist. Mit STO ist SrTO₃ gemeint. TEM ist eine Abkürzung für Transmission Electron Microscope (Transmissionselektronenmikroskop).

In der Figur 6 wird eine weniger vergrößerte Aufnahme eines Elektronenmikroskops eines hergestellten Bauteils gezeigt. Oberhalb von YBCO ist eine Maske aufgebracht, die also nicht entfernt worden ist.

Eine elektronenmikroskopische Aufnahme einer Verengung eines supraleitenden Streifens mittels fokussiertem Ionenstrahl an der Unterkante einer Stufe wird in der Figur 7 gezeigt. Es gibt eine untere Kante 7 und eine obere Kante 6. Der Querschnitt der unteren Barriere 12 bei der unteren Kante 7 beträgt ungefähr 0,2 µm x 0,6 µm (Höhe x Breite). Der Querschnitt der oberen Barriere 11 bei der oberen Kante 6 beträgt ungefähr 0,2 µm x 2 µm (Höhe x Breite). Der Supraleiter ist noch mit Maskenresten bedeckt, die beim fokussierten Ionenstrahlätzen als Schutz vor unerwünschter Kontamination und Beschädigung dienen.

## Patentansprüche

1. Bauelement mit einer Oberfläche mit einer Stufe, die eine obere Ebene (3) der Oberfläche von eine unteren Ebene (4) der Oberfläche trennt, mit Supraleitern (8, 9, 10) auf der Oberfläche, wobei bei den Kanten der Stufe jeweils ein Josephson-Kontakt vorliegt, wobei ein jeder Josephson-Kontakt durch zwei Supraleiter und einer Barriere (11, 12) zwischen den Supraleitern (8, 9, 10) gebildet ist, **dadurch gekennzeichnet, dass** der kritische Strom des einen Josephson-Kontakts größer ist als der kritische Strom des anderen Josephson-Kontakts.

2. Bauelement nach dem vorhergehenden Anspruch, **dadurch gekennzeichnet, dass** die Querschnitte der Supraleiter (8, 9) bei der einen Barriere (11) größer sind als die Querschnitte der Supraleiter 9, 10) bei der anderen Barriere (12).

3. Bauelement nach einem der vorhergehenden Ansprüche, **dadurch gekennzeichnet, dass** die Supraleiter (8, 9, 10) aus einkristallinem Material bestehen.

4. Bauelement nach dem vorhergehenden Anspruch, **dadurch gekennzeichnet, dass** die Supraleiter (8, 9, 10) aus YBCO gebildet sind.

5. Bauelement nach einem der vorhergehenden Ansprüche, **dadurch gekennzeichnet, dass** der kritische Strom des einen Josephson-Kontakts um einen Faktor 5 oder um einen 10 größer ist als der kritische Strom des anderen Josephson-Kontakts.

6. Bauelement nach einem der vorhergehenden Ansprüche, **dadurch gekennzeichnet, dass** der kritische Strom des einen Josephson-Kontakts bei der oberen Kante der Stufe größer ist als der kritische Strom des Josephson-Kontakts bei der unteren Kante.

7. Bauelement nach einem der vorhergehenden Ansprüche, **dadurch gekennzeichnet, dass** die obere Ebene (3) der Oberfläche von der unteren Ebene (4) der Oberfläche durch eine Ebene (5) der Stufe getrennt ist, die mit der oberen Ebene (3) sowie mit der unteren Ebene (4) einen Winkel einschließt, der zwischen 130° und 140° oder zwischen 133° und 137° liegt oder der 135° beträgt.

8. Bauelement nach einem der vorhergehenden Ansprüche, **dadurch gekennzeichnet, dass** das Bauelement ein einkristallines Substrat (2) mit Stufe umfasst.

9. Bauelement nach dem vorhergehenden Anspruch, **dadurch gekennzeichnet, dass** das Substrat (2) aus MgO besteht.

10. Bauelement nach einem der beiden vorhergehenden Ansprüche, **dadurch gekennzeichnet, dass** auf dem Substrat (2) eine erste Schicht (13) aus YBCO aufgebracht ist, auf der ersten Schicht (13) eine zweite Schicht (14) aus SrTiO₃ aufgebracht ist und auf der zweiten Schicht (14) eine dritte Schicht aus YBCO aufgebracht ist.

11. Bauelement nach dem vorhergehenden Anspruch, **dadurch gekennzeichnet, dass** die erste Schicht (13) dünner als die zweite Schicht (14) ist und dass die zweite Schicht (14) dünner als die dritte Schicht ist.

12. Bauelement nach einem der vorhergehenden Ansprüche, **dadurch gekennzeichnet, dass** die Breite (B1) der Supraleiter (8, 9) bei der einen Barriere (11) wenigstens 1 µm oder wenigstens 2 µm beträgt und die Breite (B2) der Supraleiter (9, 10) bei der anderen Barriere (12) nicht mehr als 800 nm oder nicht mehr als 500 nm beträgt.

13. Bauelement nach einem der vorhergehenden Ansprüche, **dadurch gekennzeichnet, dass** die Höhe der Stufe 300 nm bis 2000 nm beträgt.

14. Magnetfeldsensor mit einem Bauelement (1) nach einem der vorhergehenden Ansprüche.

15. Verfahren zur Herstellung eines Gegenstands nach einem der vorhergehenden Ansprüche, bei dem auf ein Substrat (2) mit einer Stufe eine Schicht aus supraleitendem Material aufgetragen wird und im Anschluss daran die Breite der Schicht bei einer Kante der Stufe verkleinert wird.
